(19) Europäisches Patentamt
European Patent Office
Office européen des brevets

(11) Numéro de publication: **0 208 593**
**B1**

(12) # FASCICULE DE BREVET EUROPEEN

(45) Date de publication du fascicule du brevet: **18.07.90**

(51) Int. Cl.$^5$: **G 06 J 1/00**

(21) Numéro de dépôt: **86401366.9**

(22) Date de dépôt: **23.06.86**

(54) **Procédé et dispositif d'évaluation d'un angle sur une plage étendue.**

(30) Priorité: **09.07.85 FR 8510458**

(43) Date de publication de la demande:
**14.01.87 Bulletin 87/03**

(45) Mention de la délivrance du brevet:
**18.07.90 Bulletin 90/29**

(84) Etats contractants désignés:
**BE CH DE GB LI**

(56) Documents cités:
**EP-A-0 108 671**
**FR-A-2 083 381**
**FR-A-2 237 250**
**US-A-3 678 399**

(73) Titulaire: **SCHLUMBERGER INDUSTRIES**
**50, avenue Jean Jaurès**
**F-92120 Montrouge (FR)**

(72) Inventeur: **Berard, Michel**
**176, rue de Paris**
**F-91120 - Palaiseau (FR)**

(74) Mandataire: **Weinmiller, Jürgen et al**
**Lennéstrasse 9 Postfach 24**
**D-8133 Feldafing (DE)**

**EP 0 208 593 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

## Description

La présente invention concerne un procédé et un dispositif pour évaluer la variation, à partir d'un instant initial, d'un angle A susceptible de varier sur une plage supérieure à 90°, en utilisant des valeurs instantanées d'au moins un signal indicateur pair $FC_2$ et, d'un signal indicateur impair $FS_2$, respectivement représentatifs des signes du cosinus et du sinus de l'angel double 2A.

Il est fréquent, dans le domaine de l'optique, de produire ou d'avoir à traiter des signaux qui sont des fonctions trigonométriques d'une grandeur à mesurer.

En particulier, comme le montre l'article de A. J. Rogers: "Optical methods for measurement of voltage and current on power systems/Optics and Laser Technology/December 1977/pages 273 à 283", ou l'article de A. M. Smith: "Polarization and magnetooptic properties of single-mode optical fiber/Applied optics, vol. 17, No. 1/ler Janvier 1978/pages 52 à 56", ou bien encore l'article de A. Papp et H. Harms: "Magnetooptical current transformer/Applied optics/15 Novembre 1980/Vol. 19, No. 22/pages 3729 à 3734", des mesures de courant par effet Faraday conduisent à la production de signaux trigonométriques qui sont proportionnels au sinus et au cosinus du double de l'angle de rotation du plan de polarisation d'un faisceau lumineux.

Comme on le sait, deux fonctions trigonométriques déphasées, telles que sinus et cosinus, ne peuvent définir un angle qu'à un nombre entier de tours près. Il est donc nécessaire, lorsqu'un angle est susceptible d'évoluer sur plus de 360°, de prévoir des moyens pour compter le nombre de tours effectués par cet angle dans un sens ou dans l'autre.

Un exemple de dispositif connu, permettant la mesure d'un angle sur une plage supérieure à 360°, est donné par le brevet allemand DE 3 006 840.

Cependant ce dispositif n'est adapté qu'à la mesure du déphasage entre un signal de référence et un signal de mesure, et ne correspond pas au préambule développé ci-dessus.

Le but de l'invention consiste au contraire à proposer un procédé et un dispositif permettant la mesure, sur une plage étendue et virtuellement infinie, d'un angle qui n'est connu que par l'intermédiaire de fonctions trigonométriques.

En particulier, l'invention vise à l'obtention d'une mesure sûre et correcte même lorsque cet angle évolue rapidement et/ou peut changer de sens de façon aléatoire.

De US—A—3 678 399 est déjà connu d'évaluer la variation, à partir d'un instant initial, d'un angle A susceptible de varier sur une plage supérieure à 90° et de produire un signal de sortie, dont la variation représente, exprimée en nombre de quarts de tours, la variation de l'angle A depuis ledit instant initial.

Le procédé de l'invention, qui utilise les valeurs instantanées d'un signal indicateur pair $FC_2$ et, d'un signal indicateur impair $FS_2$, respectivement représentatifs des signes du sinus et du cosinus de l'angle double 2A, comprend les opérations consistant à:

a) mettre et garder en mémoire, à partir de l'instant initial, deux nombres compteurs, $N_0$, $N_1$,

b) définir un paramètre de localisation X en lui assignant, en fonction de la valeur instantanée du signal indicateur pair $FC_2$, la valeur de l'un ou de l'autre des nombres compteurs,

c) mettre à jour l'autre des deux nombres compteurs, en lui assignant pour nouvelle valeur celle du paramètre de localisation X augmentée ou diminuée d'une unité suivant la valeur instantanée du produit des deux signaux indicateurs,

d) réitérer au cours du temps les opérations b) et c), et

e) produire au moins un premier signal de sortie, lié au paramètre de localisation X et dont la variation représente, exprimée en nombre de quarts de tours, la variation de l'angle A depuis l'instant initial.

De préférence, les signaux indicateurs pair et impair sont des représentations directes respectives des signes du cosinus et du sinus de l'angle double 2A et le nombre compteur remis à jour pendant l'opération c) prend la valeur du paramètre de localisation augmentée d'une unité si le produit des signaux indicateurs est positif et diminuée d'une unité si ce produit est négatif.

Sous une forme de réalisation plus complète, bien que non nécessaire dans toutes les applications, le procédé de l'invention peut, en utilisant un signal C de voie cosinus proportionnel au cosinus de l'angle A et un signal S de voie sinus proportionnel au sinus de cet angle, comprendre les opérations supplémentaires consistant à choisir un signal de mesure M respectivement proportionnel aux signaux de voie cosinus et sinus lorsque le signal indicateur pair est respectivement négatif et positif, et à améliorer l'évaluation de l'angle A en assignant à cet angle la valeur représentée par la somme algébrique du premier signal de sortie et d'un second signal de sortie égal à l'arc sinus du signal de mesure M. Le coefficient de proportionnalité liant M à C ou M à S est tel que M s'exprime directement par cos A ou par sin A.

L'angle A peut alors être évalué à partir de l'expression:

$$X \cdot 90° + (FC_2) \cdot (FS_2) \cdot \text{Arc sin} \mid M \mid, \text{ où}$$

X est le paramètre de localisation, $(FC_2)$ et $(FS_2)$ sont respectivement des signaux indicateurs pair et impair prenant les valeurs +1 ou −1 suivant le signe positif ou négatif du cosinus et du sinus de l'angle double 2A, respectivement, et où $|M|$ désigne la valeur absolue du signal de mesure.

A titre de variante contenue dans la présente invention, le signal de mesure M peut être élaboré de manière à être égal à $|\cos A|$ ou à $|\sin A|$ selon que le signal indicateur pair est négatif ou positif, l'angle A étant alors évalué à partir de l'expression:

$X . 90° + (FC_2) . (FS_2) . \text{Arc sin } M.$

Si la fonction Arc sin est définie sur une plage couvrant au moins l'intervalle de −45° à +45°, l'angle A peut aussi être évalué à partir de l'expression:

$$X . 90° + FD . \text{Arc sin } M,$$

où X est le paramètre de localisation, FD est un signal indicateur déphasé, prenant les valeurs +1 ou −1 suivant le signe de la différence C—S des signaux des voies cosinus et sinus, et où M ets le signal de mesure.

Le dispositif de l'invention, essentiellement destiné à mettre en oeuvre le procédé, est caractérisé en ce qu'il comprend:

deux mémoires vives,

des moyens d'adressage pour la lecture de mémoire, sensibles au signal indicateur pair et propres à délivrer sur une première sortie de ce dispositif un signal de localisation X représentatif du contenu de l'une des deux mémoires, sélectionnée suivant la valeur du signal indicateur pair,

un circuit opérateur propre, suivant la valeur du produit des signaux indicateurs pair et impair, à incrémenter ou à décrémenter la valeur du signal de localisation X, et

des moyens d'adressage pour l'enregistrement en mémoire propres à placer dans celle des deux mémoire qui n'est pas sélectionnée la valeur du signal de localisation X telle que modifiée par le circuit opérateur.

Ce dispositif peut en outre comprendre un circuit de conversion trigonométrique inverse recevant un signal de mesure M lié, en fonction de la valeur du signal indicateur pair, soit au cosinus de l'angle A, soit au sinus de l'angle A, et délivrant sur une seconde sortie de ce dispositif un signal représentatif d'une fonction trigonométrique inverse de ce signal de mesure.

Un mode particulier de réalisation de l'invention sera décrit ci-après, à titre indicatif et nullement limitatif, en référence aux dessins annexés, parmi lesquels:

La figure 1 représente un dispositif, n'appartenant pas à l'invention, donné à titre d'exemple de montage opto-électronique produisant des signaux représentés par des fonctions trigonométriques d'un angle susceptible de subir une rotation de plusieurs tours;

La figure 2 représente, en fonction des variations de l'angle A à mesurer, la valeur de différents signaux utilisés dans l'invention ou utiles pour sa compréhension;

La figure 3 représente l'organigramme du procédé, tel qu'il est mis en oeuvre de façon itérative dans le temps par un microprocesseur ou de façon essentiellement continue ou tout au moins asynchrone par un circuit électronique;

La figure 4 représente, de façon schématique, un dispositif électronique mettant en oeuvre le procédé de l'invention sous une forme complète.

La figure 1 est un montage de mesure de courant par effet Faraday.

Un courant i circule dans un conducteur 1 autour duquel est enroulée, sur un ou plusieurs tours, une fibre optique monomode 2.

Une diode laser 3 injecte, à une extrémité de la fibre, à travers une optique appropriée comprenant par exemple deux lentilles 4a, 4b disposées de part et d'autre d'un polariseur 5, un faisceau de lumière linéairement polarisé.

Le faisceau émergent, traversant une lentille 6a, est divisé en deux faisceaux secondaires grâce par exemple à un miroir semi-transparent 7.

L'un des faisceaux secondaires, traversant un analyseur 8 et une lentille 6b, est détecté par un photodétecteur 9 qui produit un signal électrique $V_c$ proportionnel à l'intensité du faisceau lumineux reçu.

De façon similaire, l'autre faisceau secondaire, traversant un analyseur 10 et une lentille 6c, est détecté par un photodétecteur 11 qui produit un signal électrique $V_s$ proportionnel à l'intensité du faisceau lumineux reçu.

En l'absence de courant i, la direction de polarisation du faisceau émergent, qui sera prise pour référence, ne dépend que de la direction de l'axe de polarisation du polariseur 5 et de l'éventuelle activité optique de la fibre 2.

Cependant, en présence de courant i, la direction de polarisation du faisceau émergent fait avec la direction de référence un angle $a_F$ (angle Faraday) dont la valeur, proportionnelle au courant i et au nombre de spires de fibre autour du conducteur 1, peut évoluer sur une plage aussi large que nécessaire, et par exemple supérieure à 360°.

La direction de l'axe de l'analyseur 8 coïncide avec la direction de référence, de sorte que le signal $V_c$ produit par le photodétecteur 9 est proportionnel à $\cos^2(a_F)$, c'est-à-dire encore égal à $K_c . [1+\cos(2 . a_F)]$ où $K_c$ est un terme lié à l'intensité du faisceau secondaire dévié vers l'analyseur 8 et au gain du photodétecteur 9.

La direction de l'axe de l'analyseur 10 fait par contre un angle de 45° avec la direction de référence, de sorte que le signal $V_s$ produit par le photodétecteur 11 est proportionnel à $\cos^2(45°-a_F)$, c'est-à-dire encore égal à $K_s . [1+\sin(2a_F)]$ où $K_s$ est un terme lié à l'intensité du faisceau secondaire transmis vers l'analyseur 10 et au gain du photodétecteur 11.

Si les voies optiques et les gains des photodétecteurs sont équilibrés, on obtient donc deux signaux:

$$V_c = K . (1+\cos A)$$
$$V_s = K . (1+\sin A)$$

où $K = K_s = K_c$ et où $A = 2 . a_F$.

En multipliant ces signaux par 1/K dans les multiplieurs respectifs 12 et 13 et en éliminant le terme constant "1" dans des amplificateurs respectifs 14 et 15, on peut obtenir deux signaux C et S tels que C=cos A et S=sin A.

L'amplitude H des signaux C et S, représentant directement des fonctions trigonométriques orthogonales de l'angle A à mesurer, est portée sur la figure 2, en fonction de cet angle A.

A partir des signaux C et S (figure 2) ou de signaux constitués par des combinaisons de ceux-ci, il est possible, de façon connue, de produire des signaux liés au cosinus ou au sinus d'angles multiples ou sous-multiples de l'angle A à mesurer, où à leur polarité.

Ainsi, à partir des signaux C et S, il est possible de former un signal $FC_2$ lié au signe du cosinus de l'angle double 2A; comme le cosinus de l'angle double 2A est une fonction paire de cet angle 2A, le signal $FC_2$ sera dit signal indicateur pair.

Par exemple:

$FC_2 = |C| - |S|$, ou
$FC_2 = C^2 - S^2$, ou
$FC_2 = C^4 - S^4$, etc.

En l'occurence, la polarité positive ou négative d'un signal $FC_2$ ainsi formé révèle un signe positif ou négatif de la fonction cos (2A).

De même, à partir des signaux C et S ou de leur polarité FC et FS, il est possible de former un signal $FS_2$ lié au signe du sinus de l'angle double 2A; comme sin (2A) est une fonction impaire de 2A, $FS_2$ sera dit signal indicateur impair.

Par exemple:

$FS_2 = FC \cdot FS$ ou
$FS_2 = C \cdot S$ ou
$FS_2 = C^3 \cdot S^3$, etc.

En l'occurence, la polarité positive ou négative d'un signal $FS_2$ ainsi formé revèle un signe positif ou négatif de la fonction sin (2A).

Le procédé de l'invention utilise le signal indicateur pair $FC_2$ et le produit $FC_2 \cdot FS_2$ des signaux indicateurs.

Dans la mesure où le produit $FC_2 \cdot FS_2$ représente le signe du sinus de l'angle quadruple 4A, il est équivalent de dire que le procédé de l'invention utilise les signaux indicateurs pair et impair $FC_2$, $FS_2$, ou le signal indicateur pair $FC_2$ et le produit des signaux indicateurs $FC_2 \cdot FS_2$, ou bien encore le signal indicateur pair $FC_2$ et un signal indicateur impair d'ordre 4, $FS_4$, lié au signe du sinus de l'angle quadruple 4A.

Le procédé comprend la mise en mémoire de deux nombres compteurs $N_0$, $N_1$ (voir figures 2 et 3) qui, par commodité seront choisis comme étant entiers.

A un instant initial, pour lequel la valeur absolue de l'angle A est par exemple inférieure à 45°, le nombre $N_0$ est mis à zéro. La valeur du nombre $N_1$ à cet instant initial est sans importance, comme on le verra immédiatement.

Le procédé comprend, après cette phase d'initialisation, les deux opérations suivantes qui doivent être exécutées continûment dans le temps, ou au moins de façon itérative, aussi longtemps que l'angle A doit être évalué; dans le cas d'un processus itératif, la fréquence des itérations doit être telle que la variation de l'angle A entre deux itérations soit inférieure à 45°.

La première opération consiste à définir un paramètre de localisation X. Ce paramètre est égal à $N_0$ si $FC_2$ est positif et à $N_1$ si $FC_2$ est négatif. Sur la figure 2, le paramètre de localisation X est représenté en trait plein, sur les variations de $N_0$ et de $N_1$; à l'instant initial, pour lequel on a supposé $|A|$ inférieur à 45°, $N_0=0$ et $X=N_0=0$.

La seconde opération consiste à mettre à jour l'autre des deux nombres compteurs, c'est-à-dire $N_0$ si $FC_2$ est négatif et $N_1$ si $FC_2$ est positif. Cet autre nombre compteur adopte alors la valeur du paramètre de localisation X augmentée ou diminuée d'une unité selon que le produit $FC_2 \cdot FS_2$ des signaux indicateurs est positif ou négatif. Ainsi, juste après l'instant initial, pour lequel $N_0=0$, la valeur de l'entier compteur $N_1$ (a priori quelconque) est fixée à +1 si A est positif et inférieur à 45° et à −1 si A est négatif ou nul et supérieur à −45°.

Dans ces conditions, le paramètre de localisation X (ou sa variation depuis l'instant initial, s'il n'est pas remis à zéro à cet instant) indique, en nombre de quarts de tours, la variation de l'angle A depuis l'instant initial.

Les opérations décrites peuvent être suivies sur la figure 3 qui donne l'organigramme de fonctionnement d'un microprocesseur mettant en oeuvre le procédé de l'invention. Sur cette figure, les grandeurs entre parenthèses $(FC_2)$ et $(FS_2)$ désignent des valeurs normées des signaux $FC_2$ et $FS_2$. Ainsi, $(FC_2)$ vaut +1 si $FC_2$ est positif et −1 si $FC_2$ est négatif (ou nul); de même $(FS_2)$ vaut +1 si $FS_2$ est positif et −1 si $FS_2$ est négatif (ou nul).

Il est possible, dans certaines applications, que l'évaluation de la variation de l'angle A en quarts de tours soit d'une précision insuffisante.

Il est alors nécessaire d'utiliser pleinement l'information portée par les signaux trigonométriques tels que C=cos(A) et S=sin(A) en plus des informations de signe telles que $FC_2$ et $FS_2$ utilisées jusqu'à présent.

Les opérations supplémentaires nécessaires sont également représentées sur la figure 3.

Elles consistent essentiellement, à partir de signaux de voie cosinus tel que k . cos A et de voie sinus tel que k . sin A, à choisir, en fonction de la valeur du signal indicateur pair $FC_2$, un signal de mesure M proportionnel, par un facteur 1/k, soit au signal k . cos A, soit au signal k . sin A, c'est-à-dire égal à cos A ou à sin A.

Dans l'exemple choisi, le signal de voie cosinus est C=cos A et le signal de voie sinus est S=sin A, de sorte que le facteur k est égal à 1, et que le signal M est directement pris égal à C ou à S.

Plus précisément, comme le montrent ces figures 2 et 3, le signal de mesure M est pris égal à S lorsque le signal indicateur pair $FC_2$ est positif, et égal à C dans le cas contraire.

Dans ces conditions, l'angle A évoluant à partir d'un instant initial pour lequel sa valeur absolue était inférieure à 45°, peut à tout moment être évalué par l'expression:

$$A = X \cdot 90° + (FC_2) \cdot (FS_2) \cdot \text{Arc sin} |M|,$$

où X est le paramètre de localisation (en trait plein sur les lignes de $N_0$ ou de $N_1$ sur la figure 2), où

$(FC_2)$ et $(FS_2)$ prennent les valeurs +1 ou −1 suivant la polarité positive ou négative de $FC_2$ et $FS_2$, et où Arc sin | M | est l'arc sinus de la valeur absolue du signal de mesure M.

Le signal de mesure M peut aussi être élaboré de manière à être égal à | C | pour $FC_2$ négatif et à | S | pour $FC_2$ positif; l'angle A est alors évalué par l'expression:

$$A=X\,.\,90°+(FC_2)\,.\,(FS_2)\,.\,\text{Arcsin } M$$

Dans ces deux cas, la fonction Arc sin n'a besoin d'être définie que sur une plage positive couvrant l'intervalle de 0 à 45°.

Si la fonction Arc sinus est définie sur une plage symétrique couvrant l'intervalle de −45°, à +45°, l'angle A peut être évalué par l'expression:

$$A=X\,.\,90°+FD\,.\,\text{Arc sin } M,$$

où FD est un signal indicateur déphasé (voir figure 2), prenant les valeurs +1 ou −1 suivant le signe, positif ou négatif, de la différence C−S des signaux C et S.

De préférence, la fonction Arc sin est définie sur une plage supérieure à l'intervalle de −45° à +45°. En effet, un avantage essentiel de l'invention considérée dans sa forme de réalisation la plus complète est de conduire à une évaluation correcte de l'angle A à tout instant T, même si les grandeurs X, $(FC_2)$ et $(FS_2)$ sont relatives à un instant antérieur T—t. Les seules conditions à respecter sont que l'angle A ait varié de moins de 45° entre les instants T—t et T, que le signal M soit bien représentatif du cosinus ou du sinus de l'angle A, ou de leur valeur absolue, à l'instant T, et que la fonction Arc sin ait aussi été définie pour des valeurs de M supérieures, en valeur absolue, à sin 45°.

L'homme de l'art pourra par ailleurs utiliser d'autres fonctions trigonométriques inverses que la fonction Arcsinus dans le but d'obtenir une évaluation correcte et précise de l'angle A, et en particulier la fonction Arccos y dont on sait qu'elle est liée à la fonction Arcsin y par la relation:

$$\text{Arcsin } y=90°-\text{Arccos } y.$$

Il reste néanmoins que l'invention, telle que décrite, permet l'évaluation de l'angle A au moyen d'une seule fonction trigonométrique inverse.

La figure 4 est un schéma d'un dispositif électronique mettant en oeuvre le procédé de l'invention.

Ce dispositif reçoit sur deux entrées 16 et 17 les signaux C=cos A et S=sin A précédemment définis.

Deux redresseurs respectifs 18, 19 produisent des signaux redressés | C | et | S | d'amplitudes respectives égales à celles des signaux C et S mais de signe positif.

Un comparateur 20 recevant les signaux | C | et | S | produit à sa sortie un signal $FC_2$= | C | − | S | dont la polarité correspond au signe du cosinus de l'angle double 2A. Un inverseur 24 produit le signal complémentaire $\overline{FC_2}$ qui se trouve au niveau bas lorsque le signal $FC_2$ est au niveau haut et inversement.

Les signaux C et S parviennent également à deux comparateurs 21 et 22 produisant des signaux de sortie respectifs correspondant aux polarités de ces signaux C et S. Les signaux de sortie de ces comparateurs sont délivrés à une porte logique OU-EXCLUSIF-NON 23 délivrant un signal $FS_2$=FC . FS dont la polarité correspond au signe du sinus de l'angle double 2A.

Les signaux $FC_2$ et $FS_2$ sont transmis à une porte logique OU-EXCLUSIF 25 qui, en combinaison avec un inverseur 26, produit les signaux $\overline{FC_2\,.\,FS_2}$ et $FC_2\,.\,FS_2$, dont chacun se trouve au niveau bas lorsque l'autre se trouve au niveau haut.

Le signal $\overline{FC_2\,.\,FS_2}$ contrôle la fermeture lorsqu'il est au niveau haut, et l'ouverture lorsqu'il est au niveau bas, d'un commutateur 27 reliant une source de potentiel de valeur −1 à un additionneur 28.

De même le signal $FC_2\,.\,FS_2$ contrôle la fermeture lorsqu'il est au niveau haut, et l'ouverture lorsqu'il est au niveau bas, d'un commutateur 29 reliant une source potentiel de valeur +1 à l'additionneur 28.

De cette façon, l'additionneur 28 reçoit sur une première entrée 28a un signal $(FC_2)\,.\,(FS_2)$ de valeur +1 lorsque les signaux indicateurs $FC_2$ et $FS_2$ sont de même polarité, et de valeur −1 dans le cas contraire.

Le dispositif comprend par ailleurs deux mémoires vives 30 et 31 adoptant, dans le mode de réalisation décrit, la forme d'échantillonneurs-bloqueurs capables de garder en mémoire des potentiels représentant des nombres compteurs $N_0$ et $N_1$.

Ces deux mémoires se rebouclent de façon commune sur une seconde entrée 28b de l'additionneur 28, qui constitue en même temps une première sortie 32 du dispositif.

L'accès d'enregistrement dans ces mémoires 30, 31 est contrôlé par des commutateurs d'entrée respectifs 30a, 31a, qui constituent des moyens d'adressage pour l'enregistrement en mémoire; de même, l'accès à la lecture de ces mémoires 30, 31 est contrôlé par des commutateurs de sortie respectifs 30b, 31b, qui constituent des moyens d'adressage pour la lecture des mémoires.

Les commutateurs 30a et 31b sont, dans l'exemple décrit, ouverts lorsque le signal indicateur pair $FC_2$ est au niveau haut ($\overline{FC_2}$ est alors au niveau bas), et fermés lorsque $FC_2$ est au niveau bas ($\overline{FC_2}$ est alors au niveau haut). Les commutateurs 30b et 31a sont fermés et ouverts dans les conditions inverses, de sorte que, sur la figure 4, les commutateurs disposés sur une même diagonale adoptent le même état, tandis que les commutateurs disposés sur deux diagonales différentes sont dans des états différents.

Les commutateurs d'entrée 30a et 31a relient respectivement les entrées des mémoires 30 et 31 à une sortie 28c de l'additionneur 28 (deux sorties 28c ont été représentées sur le dessin pour des raisons de clarté; en réalité ces sorties n'en font qu'une).

A un instant initial, pour lequel l'angle A est, en valeur absolue, inférieur à 45°, la mémoire vive 30 est remise à zéro par action sur son entrée RAZ. Le signal indicateur pair $FC_2$ étant alors positif, les commutateurs 30b et 31a sont fermés tandis que les commutateurs 30a et 31b sont ouverts.

La sortie 32 reçoit le signal X égal à la valeur $N_0$ mémorisée dans la mémoire 30, c'est-à-dire zéro.

La mémoire 31 reçoit le contenu de la mémoire 30, c'est-à-dire zéro, augmenté de la valeur $(FC_2) . (FS_2)$, c'est-à-dire augmenté ou diminué d'une unité selon le signe du produit des signaux indicateurs $FC_2$ et $FS_2$.

Si l'angle A vaut par exemple 40°, la mémoire 31 enregistre un signal correspondant à

$$N_0+(FC_2) . (FS_2)=0+1=1.$$

Si, à partir de cet état, l'angle A saute brusquement à 80°, la polarité du signal $FS_2$ est maintenue, mais celle du signal $FC_2$ est inversée; en conséquence tous les commutateurs 27, 29, 30a, 30b, 31a et 31b changent d'état.

La mémoire 31, qui contenait $N_1=1$ juste avant ce saut de 40° à 80°, conserve sa valeur, et cette valeur est délivrée, sous forme de signal X, à la première sortie 32 du dispositif.

En revanche, le contenu $N_0$ de la mémoire 30, qui était fixé à zéro, est dynamiquement remis à jour sous la forme

$$N_1+(FC_2) . (FS_2)=+1-1=0,$$

et un nouveau saut de l'angle A de 80° à 110°, conduisant à une inversion de la polarité de $FS_2$, donne à $N_0$ la valeur

$$N_1+(FC_2) . (FS_2)=+1+1=2.$$

Bien que le signal X délivré sur la sortie 32 soit de nature analogique dans l'exemple représenté, il est clair pour l'homme de l'art que la nature de ce signal peut être modifié par l'emploi d'un convertisseur analogique numérique.

Le dispositif comporte par ailleurs deux commutateurs 33a, 33b permettant d'amener sélectivement le signal C ou le signal S à l'entrée d'un convertisseur analogique-numérique 34.

Ces commutateurs transmettent au convertisseur le signal de mesure M=S si le signal indicateur pair $FC_2$ est positif et le signal M=C si le signal $FC_2$ est négatif.

Le convertisseur 34 produit par exemple un signal constituant une représentation numérique $|M|_N$ de la valeur absolue $|M|$ du signal de mesure.

La valeur de ce signal $|M|_N$ est utilisée comme valeur d'adresse pour la lecture d'un table de correspondance 35 effectuant une conversion Arc sinus et constituée par exemple par une mémoire morte, selon une technique connue en soi.

Le signal numérique produit par la lecture de cette table, éventuellement reconverti en un signal analogique par un convertisseur numérique-analogique 37, et représentatif de la grandeur Arc sin $|M|$, est tranmis à une seconde sortie 36 du dispositif.

Ce dispositif délivre ainsi les informations X, $(FC_2) . (FS_2)$ et Arc sin $|M|$ permettant l'évaluation de l'angle A, et par exemple son affichage sour la forme:

$$A=X . 90°+(FC_2) . (FS_2) . \text{Arcsin} |M|.$$

Dans le cas ou l'on veut utiliser un ordinateur ou un microprocesseur pour mettre en oeuvre l'invention, il suffit de programmer cet ordinateur ou ce microprocesseur de manière à se conformer à l'organigramme de la figure 3.

Dans ce dernier cas, comme dans celui d'un dispositif tel que celui de la figure 4, le bon fonctionnement, pour une vitesse donnée de variation de l'angle A, dépend de la vitesse d'exécution des différentes opérations. Dans le dispositif de la figure 4, la vitesse est limitée par les temps de commutation et de mémorisation dans les échantillonneurs-bloqueurs 30, 31. Dans un ordinateur ou un microprocesseur, la vitesse est limitée par la durée d'un cycle (acquisition de valeurs d'entrée-résultat).

Cependant, un des avantages principaux de la présente invention est de proposer un procédé fournissant une évaluation correcte de l'angle A (exprimée en nombre de quarts de tours) quelle que soit la variation de l'angle A entre deux acquisitions successives des signaux d'entrée (2ème bloc du haut de la figure 3), sous réserve que cette variation reste inférieure à 45° en valeur absolue.

L'invention est notamment applicable au traitement du signal issu d'un transformateur de courant à effet Faraday adapté à une ligne à haute tension et utilisant un seul montage opto-électronique (tel que celui de la figure 1) pour la mesure des courants de service normal de la ligne et des courants de défaut de la ligne.

On sait en effet que les courants circulant sur une ligne à haute tension en cas de défaut peuvent être très supérieurs aux courants circulant sur cette ligne en régime normal.

Il est ainsi possible qu'un transformateur de courant à effet Faraday, conçu pour produire un angle de mesure $A=2a_F$ compris entre −45° et +45° en régime normal, produise un angle de mesure $A=2 . a_F$ très différent de ces valeurs en cas de défaut.

L'application de l'invention à un tel transformateur permet d'évaluer cet angle A à tout moment, même en cas de défaut, et quelle que soit son excursion en dehors de la plage −45°, +45°.

Dans une telle application, le nombre compteur $N_0$ peut être remis à zéro à tout moment en dehors des conditions de défaut de la ligne.

On peut en particulier, pour initialiser ou réinitialiser le nombre compteur No, utiliser le fait que les défauts dans les lignes de transport d'énergie électrique sont toujours éliminés dans des intervalles de temps relativement courts, par exemple inférieurs à un intervalle de temps To.

En conséquence, si le transformateur de courant à effet Faraday est conçu pour produire un angle de mesure entre −45° et +45° en régime normal, le nombre compteur No peut être réinitialisé à zéro chaque fois qu'il reste différent de zéro pendant un intervalle de temps supérieur à To.

**Revendications**

1. Procédé pour évaluer la variation, à partir d'un instant initial, d'un angle A susceptible de varier sur une plage supérieure à 90°, en utilisant des valeurs instantanées d'au moins un signal indicateur pair $FC_2$ et d'un signal indicateur impair $FS_2$ respectivement représentatifs des signes du cosinus et du sinus de l'angle double 2A, comprenant les opérations consistant à:

a) mettre et garder en mémoire, à partir de l'instant initial, deux nombres compteurs, $N_0$, $N_1$,

b) définir un paramètre de localisation X en lui assignant, en fonction de la valeur instantanée du signal indicateur pair $FC_2$, la valeur de l'un ou de l'autre des nombres compteurs,

c) mettre à jour l'autre des deux nombres compteurs, en lui assignant pour nouvelle valeur celle du paramètre de localisation X augmentée ou diminuée d'une unité suivant la valeur instantanée du produit $FC_2 . FS_2$ des deux signaux indicateurs,

d) réitérer au cours du temps les opérations b) et c), et

e) produire au moins un premier signal de sortie, lié au paramètre de localisation X, et dont la variation représente, exprimée en nombre de quarts de tours, la variation de l'angle A depuis ledit instant initial.

2. Procédé suivant la revendication 1, caractérisé en ce que lesdits signaux indicateurs pair $FC_2$ et impair $FS_2$ sont des représentations directes respectives des signes du cosinus et du sinus de l'angle double 2A.

3. Procédé suivant la revendication 1 ou 2, caractérisé en ce que le nombre compteur remis à jour pendant l'opération c) prend la valeur du paramètre de localisation X augmentée d'une unité si le produit des signaux indicateurs est positif et diminuée d'une unité si ce produit est négatif.

4. Procédé suivant l'une quelconque des revendications précédentes, utilisant un signal C de voie cosinus proportionnel au cosinus de l'angle A et un signal S de voie sinus proportionnel au sinus de cet angle, et comprenant les opérations supplémentaires consistant à choisir un signal de mesure M respectivement proportionnel aux signaux de voie cosinus et sinus lorsque le signal indicateur pair est respectivement négatif et positif, et à améliorer l'évaluation de l'angle A en assignant à cet angle la valeur représentée par la somme algébrique du premier signal de sortie et d'un second signal de sortie égal à une fonction trigonométrique inverse du signal de mesure M.

5. Procédé suivant la revendication 4, caractérisé en ce que l'angle A est évalué à partir de l'expression:

$$X . 90°+(FC_2) . (FS_2) \text{ Arc sin } |M|, \text{ où}$$

X est le paramètre de localisation, $(FC_2)$ et $(FS_2)$ sont respectivement des signaux indicateurs pair et impair prenant les valeurs +1 ou −1 suivant le signe positif ou négatif du cosinus et du sinus de l'angle double 2A, respectivement, et où $|M|$ désigne la valeur absolue du signal de mesure.

6. Procédé suivant la revendication 4, caractérisé en ce que l'angle A est évalué à partir de l'expression: $X . 90°+FD . \text{Arcsin } M$, où X est le paramètre de localisation, FD est un signal indicateur déphasé, prenant les valeurs +1 ou −1 suivant le signe de la différence C−S des signaux des voies cosinus et sinus, et où M est le signal de mesure.

7. Dispositif pour évaluer la variation, à partir d'un instant initial, d'un angle A sur une plage supérieure à 90°, en utilisant au moins un signal indicateur pair $FC_2$ et un signal indicateur impair $FS_2$ respectivement représentatifs des signes du cosinus et du sinus de l'angle double 2A, caractérisé en ce qu'il comprend:

deux mémoires vives (30, 31),

des moyens d'adressage pour la lecture de mémoire (30b, 31b), sensibles au signal indicateur pair $FC_2$ et propres à délivrer sur une première sortie (32) de ce dispositif un signal de localisation X représentatif du contenu de l'une des deux mémoires, sélectionnée suivant la valeur du signal indicateur pair $FC_2$,

un circuit opérateur (28) propre, suivant la valeur du produit $FC_2 . FS_2$ des signaux indicateurs pair et impair, à incrémenter ou à décrémenter la valeur du signal de localisation, et

des moyens d'adressage pour l'enregistrement en mémoire (30a, 31a), propres à placer dans celle des deux mémoires qui n'est pas sélectionnée, la valeur du signal de localisation telle que modifiée par le circuit opérateur.

8. Dispositif suivant la revendication 7, caractérisé en ce qu'il comprend en outre un circuit de conversion trigonométrique inverse (35) recevant un signal de mesure (M) lié, en fonction de la valeur du signal indicateur pair, soit au cosinus de l'angle A, soit au sinus de l'angle A, et délivrant sur une seconde sortie (36) de ce dispositif un signal représentatif d'une fonction trigonométrique inverse de ce signal de mesure.

9. Application d'un procédé ou d'un dispositif selon l'une quelconque des revendications précédentes au traitement du signal produit, sous la forme de fonctions trigonométriques d'un angle de mesure, par un transformateur de courant à effet Faraday utilisant un même montage pour la mesure des courants de service normal et des courants de défaut.

**Patentansprüche**

1. Verfahren zum Bestimmen der Veränderung eines Winkels A, der sich über einen Bereich von mehr als 90° ändern kann, ausgehend von einem Anfangsmoment, unter Benutzung von Momentanwerten mindestens eines Signals $FC_2$ "geradzahlige Anzeige" und eines Signals $FS_2$ "ungeradzahlige Anzeige", die jeweils die Vorzeichen der Cosinus- und Sinusfunktionen des doppelten Winkels 2A darstellen, wobei folgende Operationen ausgeführt werden:

a) Abspeichern und Festhalten von zwei Zählerständen $N_0$, $N_1$, ausgehend von einem Anfangsmoment,

b) Definieren eines Ortsbestimmungsparameters X, indem ihm der eine oder der andere Zählerstand in Abhängigkeit vom Momentanwert des Signals $FC_2$ "geradzahlige Anzeige" zugeordnet wird,

c) Aktualisieren der anderen der beiden Zählerstände, indem ihm als neuer Wert der Wert des Ortsbestimmungsparameters X, der je nach dem Momentanwert des Produktes $FC_2 . FS_2$ der beiden Anzeigesignale um eine Einheit erhöht oder erniedrigt wird, zugeordnet wird,

d) Wiederholen der Operationen b) und c) im Laufe der Zeit, und

e) Erzeugen mindestens eines ersten an den Ortsbestimmungsparameter X gebundenen Ausgangssignals, dessen Veränderung, ausgedrückt durch die Anzahl der Vierteldrehungen, die Änderung des Winkels A seit dem Anfangsmoment darstellt.

2. Verfahren nach Anspruch 1, dadurch gekennzeichnet, daß die Signale "geradzahlige Anzeige" $FC_2$ und "ungeradzahlige Anzeige" $FS_2$ Signale jeweils der direkte Ausdruck der Cosinus- und der Sinusfunktion des Doppelwinkels 2A sind.

3. Verfahren nach Anspruch 1 oder 2, dadurch gekennzeichnet, daß der während der Operation c) aktualisierte Zählerstand den Wert des um eine Einheit vergrößerten oder verkleinerten Ortsbestimmungsparameters X annimmt, je nach dem, ob das Produkt der Anzeigesignale positiv oder negativ ist.

4. Verfahren nach einem beliebigen der vorhergehenden Ansprüche, bei dem ein dem Cosinus A proportionales Cosinuspfadsignal C und ein dem Sinus A proportionales Sinuspfadsignal S benutzt und zusätzliche Operationen ausgeführt werden, die darin bestehen, daß ein Meßsignal M gewählt wird, welches dem Cosinus- bzw. Sinuspfadsignal proportional ist, wenn das Signal "geradzahlige Anzeige" negativ bzw. positiv ist, und daß die Bestimmung des Winkels A dadurch verbessert wird, daß ihm der durch die algebraische Summe des ersten Ausgangssignals und eines zweiten Ausgangssignals, welches einer trigonometrischen Umkehrfunktion des Meßsignals M entspricht, ausgedrückte Wert zugeordnet wird.

5. Verfahren nach Anspruch 4, dadurch gekennzeichnet, daß der Winkel A auf der Basis des folgenden Ausdruckes bestimmt wird:

$$X . 90°+(FC_2) . (FS_2) . \text{Arc sin} \mid M \mid;$$

darin bedeutet X den Ortsbestimmungsparameter, $(FC_2)$ und $(FS_2)$ die Signale "geradzahlige Anzeige" bzw. "ungeradzahlige Anzeige", welche dem positiven bzw. negativen Vorzeichen des Cosinus bzw. des Sinus der Doppelwinkels 2A entsprechend die Werte +1 oder −1 annehmen, und $\mid M \mid$ den Absolutwert des Meßsignals.

6. Verfahren nach Anspruch 4, dadurch gekennzeichnet, daß der Winkel A auf der Basis des folgenden Ausdruckes bestimmt wird:

$$X . 90°+FD . \text{Arc sin } M;$$

darin bedeutet X den Ortsbestimmungsparameter, FD—eine phasenverschobenes Anzeigesignal, welches je nach dem Vorzeichen der Differenz C−S der Cosinus- und Sinuspfadsignale die Werte +1 oder −1 annimmt, und M das Meßsignal.

7. Einrichtung zum Bestimmen der Veränderung eines Winkels A, der sich über einen Bereich von mehr als 90° ändern kann, ausgehend von einem Anfangsmoment, unter Benutzung von mindestens einem Signal $FC_2$ "geradzahligen Anzeige" und einem Signal $FS_2$ "ungeradzahlige Anzeige", die die Vorzeichen der Cosinus- bzw. Sinsufunktion des doppelten Winkels 2A darstellen, dadurch gekennzeichnet, daß sie folgende Komponenten aufweist:

zwei Aktivspeicher (30, 31);

Adressiermittel (30b, 31b) zum Speicherlesen, die auf das Signal $FC_2$ "geradzahlige Anzeige" ansprechen und in der Lage sind, an einem ersten Ausgang (32) der Einrichtung ein Ortsbestimmungssignal X zu liefern, das den Inhalt jenes der beiden Speicher darstellt, der entsprechend dem Wert des Signals $FC_2$ "geradzahlige Anzeige" gewählt wird;

eine Rechenschaltung (28), die entsprechend dem Wert des Produktes $FC_2 . FS_2$ der geradzahligen und der ungeradzahligen Anzeige den Wert des Ortsbestimmungssignals erhöhen oder erniedrigen kann, und

Adressiermittel (30a, 31a) zum Speichereinschreiben, die in der Lage sind, in dem nicht gewählten der beiden Speicher den Wert des durch die Rechenschaltung geänderten Ortsbestimmungssignals abzulegen.

8. Einrichtung nach Anspruch 7, dadurch gekennzeichnet, daß sie weiter eine Schaltung (35) zur trigonometrischen Kehrwertbildung aufweist, die ein Meßsignal empfängt, das in Abhängigkeit vom Wert des Signals "geradzahlige Anzeige", entweder an den Cosinus des Winkels A oder an den Sinus des Winkel A gebunden ist, und das an einem zweiten Ausgang (36) ein Signal liefert, welches eine trigonometrische Umkehrfunktion des Meßsignals darstellt.

9. Anwendung eines Verfahrens oder einer Einrichtung nach einem beliebigen der vorhergehenden Ansprüche auf die Verarbeitung des Signals, das in Form trigonometrischer Funktionen eines Meßwinkels durch einen Faraday-Effekt-Stromtransformator erzeugt wird, der zum Messen der normalen Betriebsströme den gleichen Schaltungsaufbau wie zum Messen der Fehlerströme verwendet.

## Claims

1. A method for evaluating the variation, from an initial instant, of an angle A capable of varying over a range greater than 90°, by using instantaneous values of at least an even indicator signal $FC_2$ and an odd indicator signal $FS_2$, respectively representative of the signs of the cosine and the sine of the double angle 2A, comprising the steps:

a) putting and storing in memory, from an initial instant, two counter numbers, $N_0$, $N_1$;

b) defining a localisation parameter X by assigning to it, as a function of the instantaneous value of the even indicator signal $FC_2$, the value of one or other of the counter numbers;

c) updating the other of the counter numbers, by assigning it as new value the localisation parameter X increased or decreased by one unit according to the instantaneous value of the product $FC_2 . FS_2$ of the two indicator signals,

d) repeating the operations b) and c) in the course of time; and

e) producing at least a first output signal, related to the localisation parameter X and whose variation represents, expressed in numbers of quarter turns, the variation of the angle A since the initial instant.

2. A method according to claim 1, characterised in that the even and odd indicator signals $FC_2$ and $FS_2$ are respective direct representations of the signs of the cosine and the sine of the double angle 2A.

3. A method according to claim 1 or claim 2, characterized in that the counter number updated during operation c) takes the value of the localisation parameter X increased by one unit if the product of the indicator signals is positive and decreased by one unit if this product is negative.

4. A method according to any one of the preceding claims, using a cosine channel signal C proportional to the cosine of the angle A and a sine channel signal proportional to the sine of this angle, and comprising the supplementary operations consisting in choosing a measurement signal M proportional to the cosine and sine tracking signals respectively when the even indicator signal is negative or positive respectively, and improving the evaluation of the angle A by assigning to this angle the value represented by the algebraic sum of the first output signal and of a second output signal equal to an inverse trigonometrical function of the measurement signal M.

5. A method according to claim 4, characterized in that the angle A is evaluated from the expression

$$X . 90°+(FC_2) . (FS_2) \text{ Arc sin } |M|,$$

where X is the localisation parameter, $(FC_2)$ and $(FS_2)$ are respectively the even and odd indicator signals taking the values +1 or −1 in accordance with the positive or negative sign of the cosine and the sine of the double angle 2A respectively, and where $|M|$ designates the absolute value of the measurement signal.

6. A method according to claim 4, characterized in that the angle A is evaluated from the expression:

$$X . 90°+FD . \text{Arc sin } M,$$

where X is the localisation parameter, FD is a phase-shifted indicator signal, taking the values +1 or −1 according to the sign of the difference C−S of the cosine and sine channel signals, and where M is the measurement signal.

7. A device for evaluating the variation, from an initial instant, of an angle A over a range greater than 90°, by using at least an even indicator signal $FC_2$ and an odd indicator signal $FS_2$ respectively representative of the cosine and sine of the double angle 2A, characterized in that it comprises:

two read/write memories,

memory reading address means (30b, 31b) responsive to the even indicator signal $FC_2$ and adapted to deliver at a first output (32) of the device a localisation signal X representative of the contents of one of the two memories, selected according to the value of the even indicator signal $FC_2$,

an operator circuit (28) adapted, according to the value of the product $FC_2 . FS_2$ of the even and odd indicator signals to increment or decrement the value of the localisation signal, and

memory writing address means (30a, 31a) adapted to write in the one of the two memories which is not selected the value of the localisation signal as modified by the operator circuit.

8. A device according to claim 7, characterized in that it additionally comprises an inverse trigonometric function conversion circuit (35) receiving a measurement signal (M) related, as a function of the value of the even indicator signal, either to the cosine of the angle A or the sine of the angle A, and supplying at a second output of the device a signal representative of an inverse trigonometrical function of the measurement signal.

9. Application of a method or a device according to any one of the preceding claims to the processing of the signal produced, in the form of trigonometric functions of a measured angle, by a Faraday effect current transformer using a common assembly for the measurement of normal operating currents and fault currents.

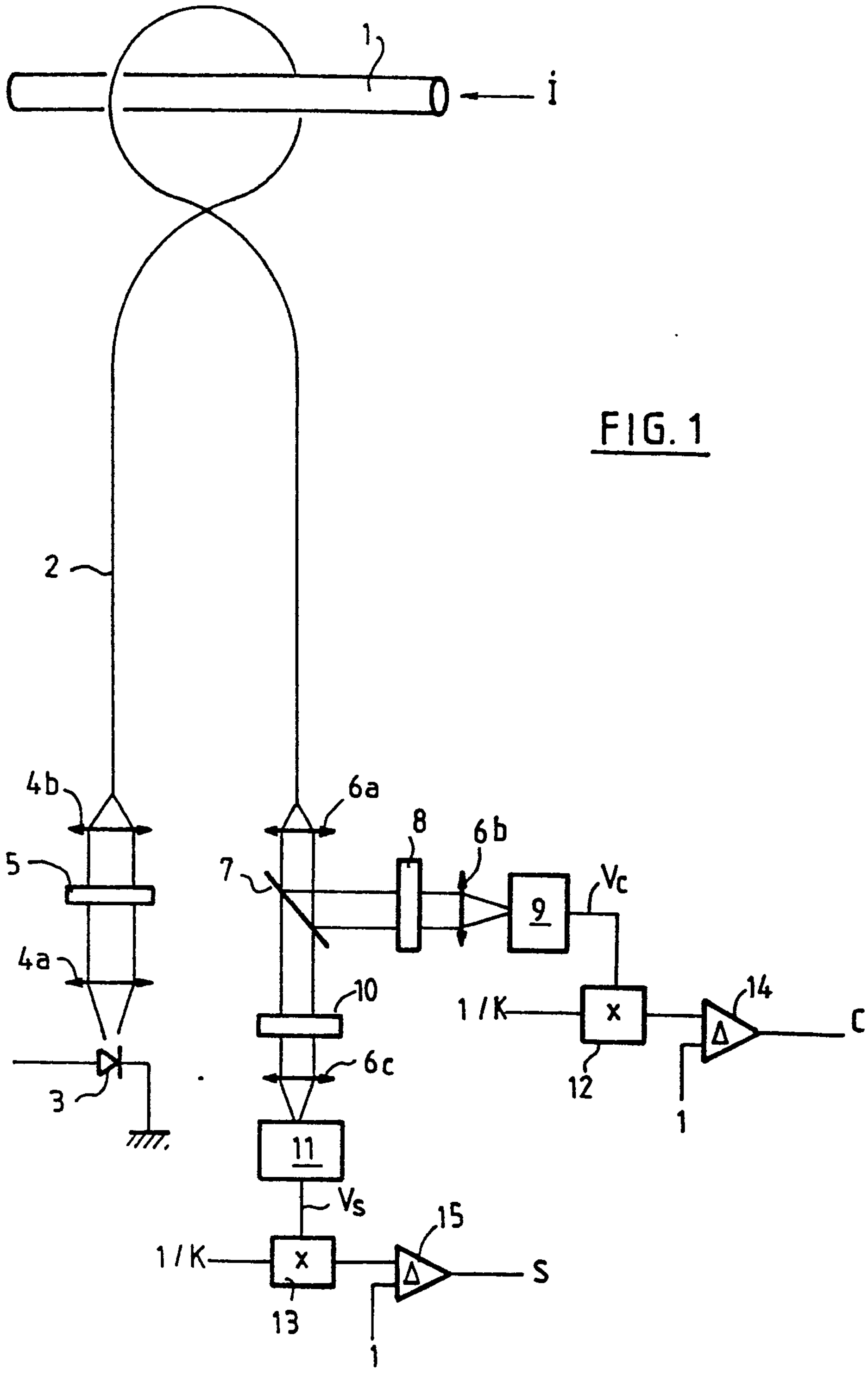


FIG. 1

FIG. 2

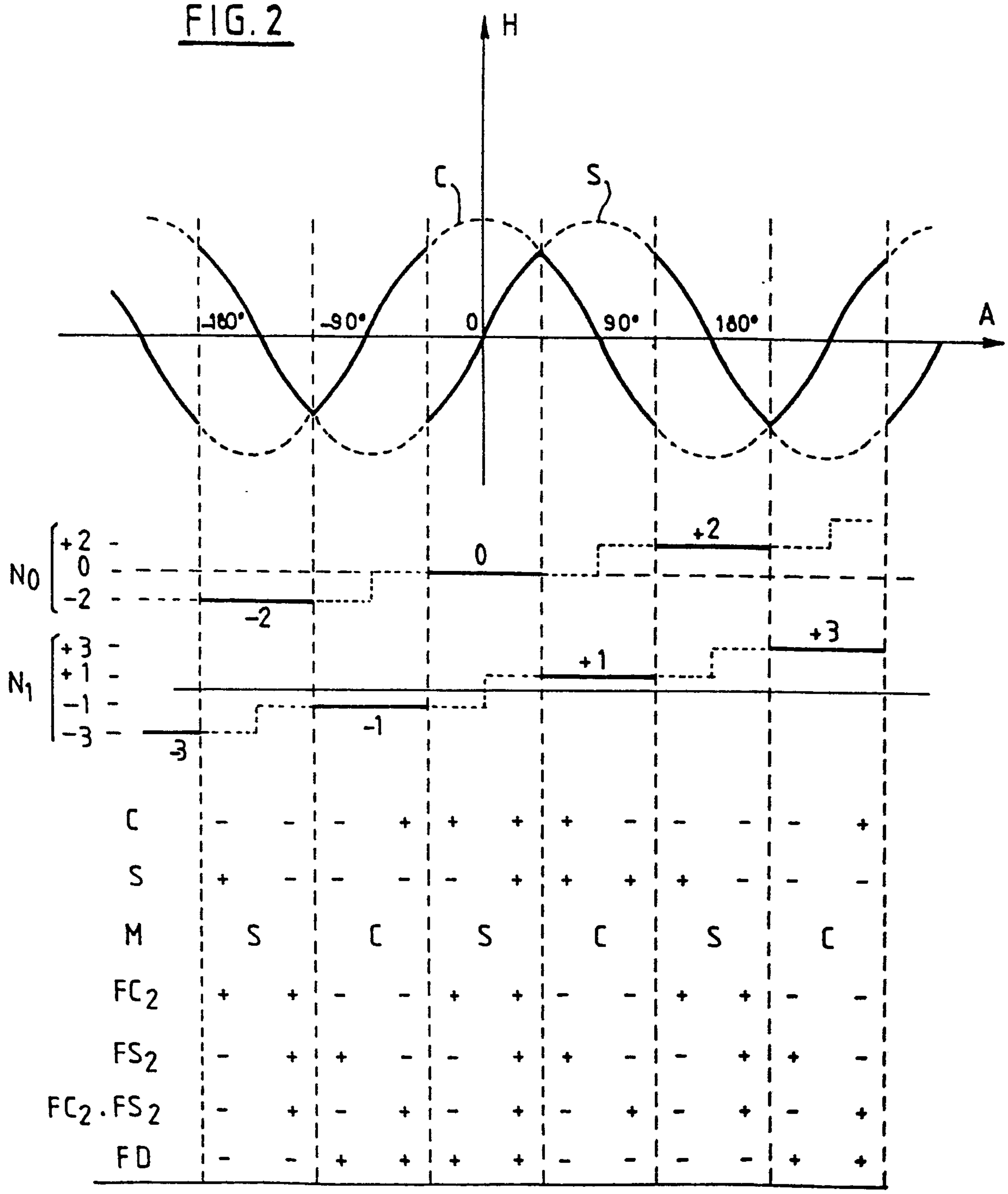

FIG. 3

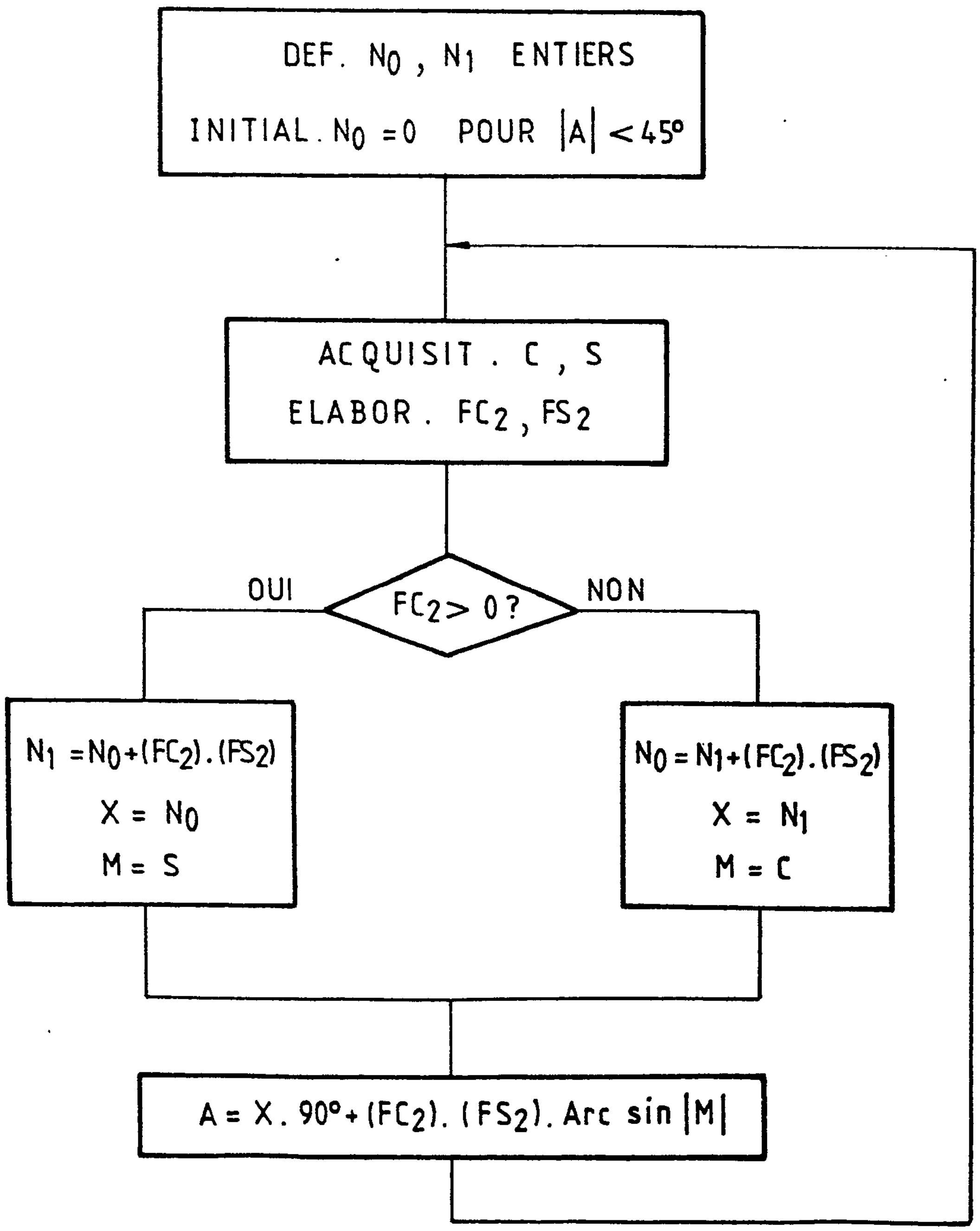
DEF. N0 , N1 ENTIERS
INITIAL. N0 =0 POUR |A| < 45°
ACQUISIT . C , S
ELABOR . FC2 , FS2
OUI
FC2 > 0 ?
NON
N1 =N0+(FC2).(FS2)
X = N0
M = S
N0 = N1+(FC2).(FS2)
X = N1
M = C
A = X . 90°+(FC2). (FS2). Arc sin |M|

FIG. 4

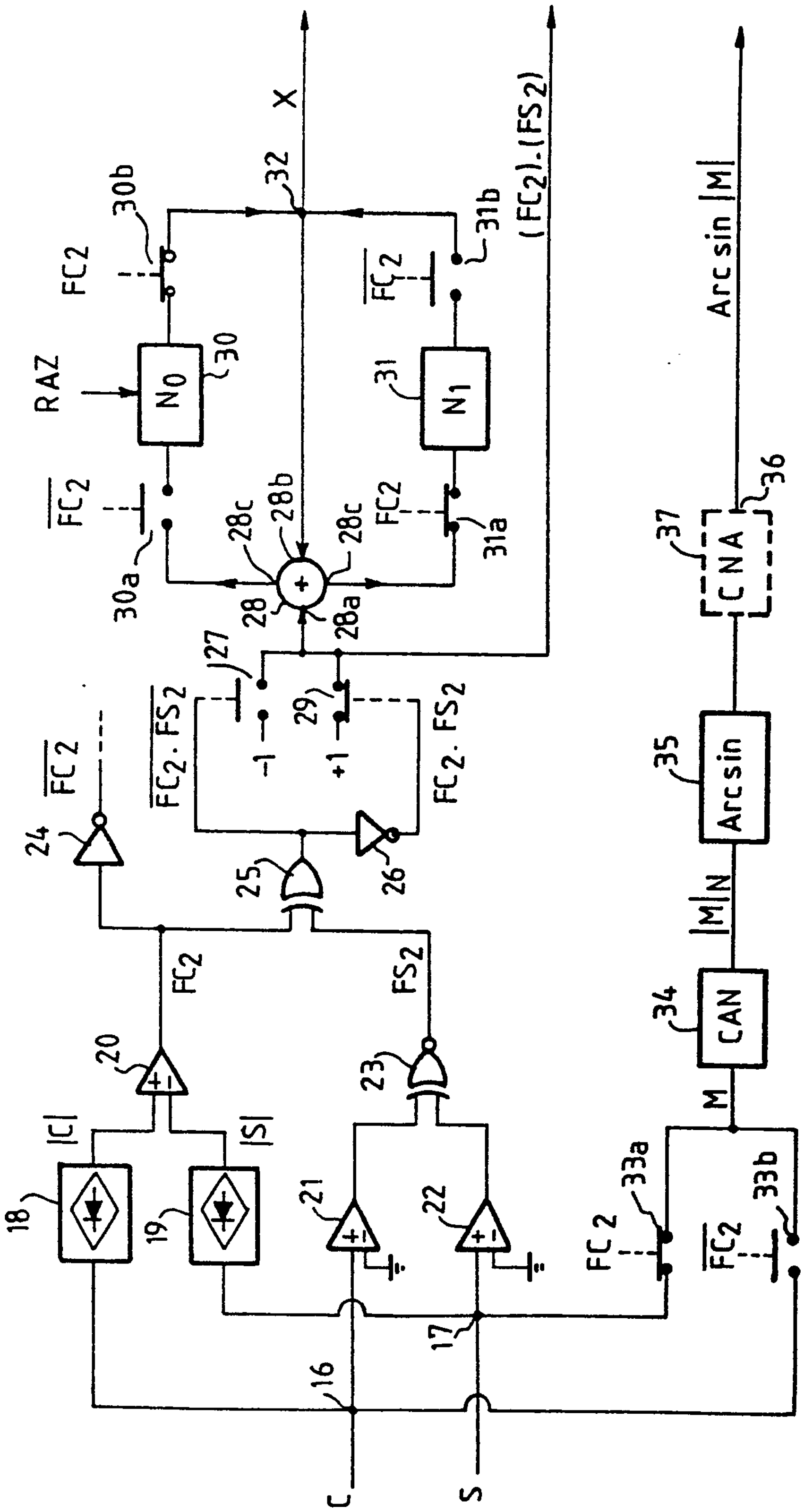
C
S
16
17
18
19
|C|
|S|
20
21
22
23
FC2
FS2
24
25
26
27
28
28a
28b
28c
29
30
30a
30b
31
31a
31b
32
N0
N1
RAZ
X
-1
+1
(FC2).(FS2)
CAN
|M|N
Arcsin
CNA
M
Arc sin |M|
33a
33b
34
35
36
37